# EUROPEAN PATENT APPLICATION

(11) **EP 1 837 933 A1**
(43) Date of publication of application: **26.09.2007**
(21) Application number: 07251069.6
(22) Date of filing: 14.03.2007
(51) Int. Cl.: H01M 2/10, E05F 1/12, E05D 11/06, E05D 3/02, B65F 1/16

(54) **Swing lid structure and electronic apparatus**

(30) Priority: 20.03.2006 JP 2006076545
(71) Applicant: Sony Corporation, Minato-ku Tokyo 108-0075 (JP)
(72) Inventor: Okuchi, Tetsuya, Tokyo 108-0075 (JP)
(74) Representative: Keston, Susan Elizabeth

(57) **Abstract**

A swing lid structure includes a body having a cavity for holding a predetermined part therein and provided with slots extending in a predetermined direction, a swing lid provided with through holes and capable of covering the cavity of the body, and a support shaft passed through the through holes of the swing lid and slidably fitted in the slots of the body. The swing lid can slide on the body as the support shaft moves in the slots and can turn on the support shaft relative to the body. The lid is subjected to a translation and then a rotation. An apparatus comprising such lid is also disclosed.

## Description

The present invention relates to a swing lid structure and an electronic apparatus.

Electronic apparatuses include, for example, video cameras, still cameras, television receivers, cellular telephones, audio devices and such. Some of those electronic apparatuses have a body provided with a cavity for holding a predetermined part, such as a rechargeable battery.

A cavity defined in a body included in an electronic apparatus disclosed in, for example, JP-UM-A-2-113895 is covered with a swing lid. The swing lid is slid to a predetermined position on the body, and then the swing lid is turned relative to the body to open the space. The swing lid of the electronic apparatus mentioned in JP-UM-A-2-113895 has a cover body and a connecting member formed by bending a metal sheet in a predetermined shape. The connecting member is supported on the body so as to be turnable, and the cover body is supported slidably on the connecting member. To open the space, first the cover body is slid on the connecting member, and then the cover body is turned together with the connecting member relative to the body.

In this known electronic apparatus, the swing lid has the cover body and the connecting member, the connecting member is supported on the body so as to be turnable relative to the body, and the cover body is supported on the connecting member so as to be slidable on the connecting member. Thus a mechanism including the swing lid and the body is inevitably complicated. A connecting member making process that bends the metal sheet in the predetermined shape is troublesome

Accordingly, it is desirable to provide a simple supporting structure, for supporting a swing lid on an electronic apparatus, capable of solving the forgoing problems.

Various respective aspects and features of the invention are defined in the appended claims. Features from the dependent claims may be combined with features of the independent claims as appropriate and not merely as explicitly set out in the claims.

Embodiments of the invention provide a technique for simplifying a swing lid structure including a swing lid rotatably and slidably supported on a body.

To address the foregoing problems, a first embodiment of the present invention is directed to a swing lid structure including: a body having a cavity for holding a predetermined part therein and provided with slots extending in a predetermined direction; a swing lid provided with through holes and capable of covering the cavity of the body; and a support shaft passed through the through holes of the swing lid and slidably fitted in the slots of the body; wherein the swing lid can slide on the body as the support shaft moves in the slots and can turn on the support shaft relative to the body.

To address the foregoing problems, a second embodiment of the present invention is directed to an electronic apparatus including: a body having a cavity for holding a predetermined part therein and provided with slots extending in a predetermined direction; a swing lid provided with through holes and capable of covering the cavity of the body; and a support shaft passed through the through holes of the swing lid and slidably fitted in the slots of the body; wherein the swing lid can slide on the body as the support shaft moves in the slots and can turn on the support shaft relative to the body.

In each of the swing lid structure and the electronic apparatus, the swing lid can slide together with the support shaft relative to the body.

The swing lid structure of the first aspect includes the body defining the cavity for holding a predetermined part therein and provided with the slots extending in a predetermined direction, the swing lid provided with the through holes and capable of covering the cavity of the body, and the support shaft passed through the through holes of the swing lid and slidably fitted in the slots of the body, and the swing lid can slide on the body as the support shaft moves in the slots, and can turn on the support shaft relative to the body.

The swing lid structure in which the swing lid is supported by the support shaft on the body so as to be slidable and turnable relative to the body is simple.

In a swing lid structure in the first aspect, the swing lid may be slidable between a first position where the swing lid can turn relative to the body and a second position where the swing lid can not turn relative to the body, a coil spring having a coil and first and second arms extending from the opposite ends of the coiled spring body, respectively, may be put on the support shaft, the swing lid may be provided with a spring retaining part against which the first arm of the coil spring is pressed, and the body may be provided with a stopping projection having a first retaining surface against which the second arm of the coil spring is pressed at least when the swing lid is at the first position, and a second retaining surface against which the second arm of the coil spring is pressed when the swing lid is at the second position so as to push the swing lid toward the first position. Thus the operator does not need to perform all the operations necessary for moving the swing lid from the first position where the swing lid is turnable to the second position where the swing lid is unturnable, which facilitates using a device provided with this swing lid structure.

In a swing lid structure in the first embodiment, the stopping projection of the body may have a restraining surface for restraining the swing lid at the second position from turning, and the first and the second retaining surface may be formed on the stopping projection. Thus the restraining surface for restraining the swing lid from turning and the retaining surfaces for bearing the second arm of the coil spring do not need to be formed separately, which simplifies the swing lid structure.

In a swing lid structure in the first embodiment, the first and the second retaining surface may be formed so as to extend perpendicularly to each other, and an inclined surface inclined to both the first and the second retaining surface may be extended between the first and the second retaining surface such that the second arm slide along the inclined surface when the swing lid slides relative to the body. Thus the swing lid can be moved by a small force to slide the swing lid from the second position toward the first position, and a moving force can be applied at an early stage of sliding the swing lid when the swing lid is slid from the first position toward the second position.

The electronic apparatus according to the second embodiment includes: the body provided with the slots extending in a predetermined direction; the swing lid provided with the through holes, and the support shaft passed through the through holes of the swing lid and slidably fitted in the slots of the body, and the swing lid can slide on the body as the support shaft moves in the slots can turn on the support shaft relative to the body.

Since the swing lid is supported by the support shaft on the body so as to be slidable and turnable relative to the body, the electronic apparatus is simple in construction.

The invention will now be described by way of example with reference to the accompanying drawings, throughout which like parts are referred to by like references, and in which:
Fig. 1 is a perspective view of a still camera in a preferred embodiment with its slide cover at a closed position;
Fig. 2 is a perspective view of the still camera shown in Fig. 1 with its slide cover at an open position;
Fig. 3 is a perspective view of the still camera shown in Fig. 1, showing the back of the still camera;
Fig. 4 is an enlarged bottom view of the still camera shown in Fig. 1;
Fig. 5 is an enlarged perspective view of a part of the still camera shown in Fig. 1;
Fig. 6 is an enlarged sectional view of a strap lug and a strap wound round the strap lug;
Fig. 7 is a perspective view of the still camera shown in Fig. 1 and a rechargeable battery removed from the still camera;
Fig. 8 is a perspective view of the still camera shown in Fig. 1 in use;
Fig. 9 is a front elevation of the still camera shown in Fig. 1 held by hand in a first holding manner;
Fig. 10 is a front elevation of the still camera shown in Fig. 1 held by hand in a second holding manner;
Fig. 11 is an enlarged, exploded perspective view of a button holding unit, a first push button module, a second push button module, and a button unit;
Fig. 12 is an enlarged perspective view of the button holding unit, the first push button module, the second push button module and the button unit;
Fig. 13 is an enlarged perspective view of the fist and the second push button module separated from each other;
Fig. 14 is an enlarged perspective view of assistance in explaining a method of combining the first and the second push button module;
Fig. 15 is an enlarged sectional view of the first and the second push button module at a stage before a connecting pin included in the first push button module is inserted into a connecting hole of the second push button module;
Fig. 16 is an enlarged perspective view of a compound push button built by combining the first and the second push button module;
Fig. 17 is an enlarged sectional view of the first and the second push button module at a stage after the connecting pin of the first push button module is inserted into the connecting hole of the second push button module;
Fig. 18 is an enlarged, exploded perspective view of a holding frame, a swing lid, a support shaft and a coil spring;
Fig. 19 is an enlarged sectional view of the holding frame shown in Fig. 18;
Fig. 20 is an enlarged perspective view of the coil spring shown in Fig. 18 with its second arm in contact with a restraining part;
Fig. 21 is an enlarged sectional view of assistance in explaining operations of the swing lid, in which the swing lid is at a second position where the swing lid is unturnable;
Fig. 22 is an enlarged sectional view of assistance in explaining operations of the swing lid, in which the swing lid has been moved from the second position to a first position where the swing lid is turnable;
Fig. 23 is an enlarged sectional view of assistance in explaining operations of the swing lid, in which the swing lid placed at the first position is being turned;
Fig. 24 is an enlarged sectional view of assistance in explaining operations of the swing lid, in which the swing lid has been turned to open a space in a body;
Fig. 25 is an enlarged sectional view of assistance in explaining operations of the swing lid, in which the swing lid has been completely turned;
Fig. 26 is an enlarged sectional view of assistance in explaining operations of the swing lid, in which the swing lid is being moved from the first position to the second position;
Fig. 27 is a typical view of assistance in explaining a force that may be generated while the swing lid is being moved from the first position to the second position;
Fig. 28 is a typical view of assistance in explaining a force that may be generated while the swing lid is being moved from the first position to the second position; and
Fig. 29 is a typical view of assistance in explaining a force that may be generated while the swing lid is being moved from the first position to the second position when the retaining part is not provided with a slope.

Embodiments of the present invention will be described as applied to a still camera by way of example. The present invention is not limited in its practical application to the still camera specifically described herein and is applicable widely to various devices including video cameras. In the following description, vertical directions and transverse directions are those as a user looks when the user uses the still camera for photographing. For example, the user is on the rear side of the still camera and an object is on the front side of the still camera. Vertical directions and transverse directions are used for convenience in the following description and do not place any restrictions on the embodiments of the present invention.

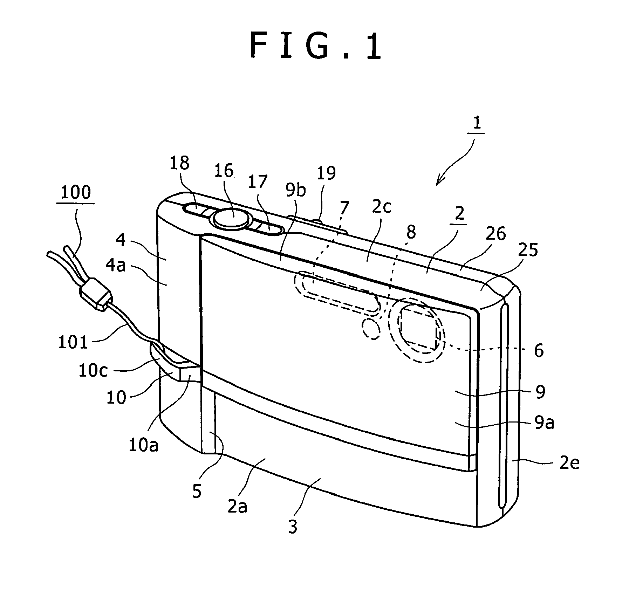

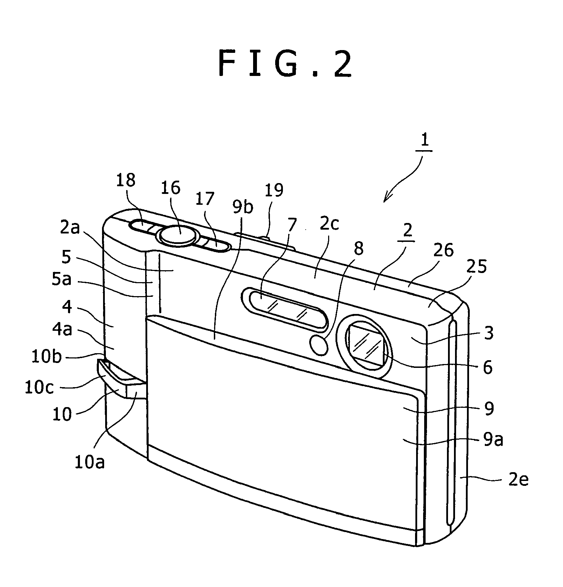

Referring to Figs. 1 to 3, a still camera 1 has a body 2 holding component parts therein. The body 2 is formed in a shape substantially resembling a flat, transversely elongate, rectangular solid. The body 2 has a front wall 2a, a rear wall 2b, a top wall 2c, a bottom wall 2d, a left side wall 2e and a right side wall 2f. As shown in Figs. 1 and 2, the surface of the front wall 2a, excluding the surface of a right end section 4, is depressed to form a recess 3. The respective surfaces of the recess 3 and the right end section 4 are connected by a vertically elongate boundary surface 5 facing obliquely leftward. A lens 6, a built-in flash 7 and a self-timer lens 8 are arranged in an upper end part of the recess 3.

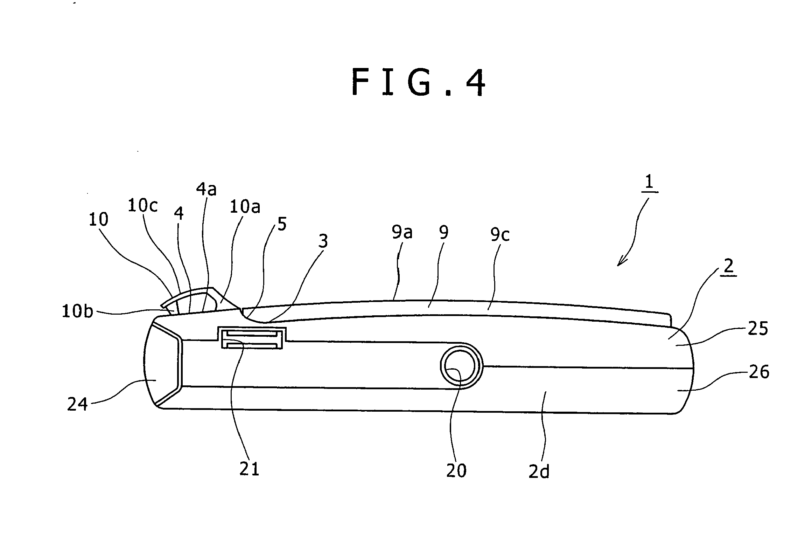

A slide cover 9 is vertically slidably supported on the surface of the recess 3. The slide cover 9 has a height lower than that of the body 2, and a width equal to that of the recess 3. The slide cover 9 has a forward convex, gently curved front surface 9a, a flat upper surface 9b and a flat lower surface 9c. The right end section 4 has a forward convex, gently curved front surface 4a of a curvature equal to that of the front surface 9a of the slide cover 9. Thus the front surface 4a of the right end section 4 is smoothly continuous with the front surface 9a of the slide cover 9 as shown in Fig. 4.

The upper surface 9b of the slide cover 9 is flush with the upper surface 2c of the body 2 when the slide cover 9 is positioned at an upper closed position as shown in Fig. 1 to cover the lens 6, the built-in flash 7 and the self-timer lens 8. The lower surface 9c of the slide cover 9 is flush with the lower surface 2d of the body 2 as shown in Fig. 2 when the slide cover 9 is positioned at a lower open position to uncover the lens 6, the built-in flash 7 and the self-timer lens 8. An electric circuit included in the still camera 1 is connected to a power source when the slide cover 9 is slid from the closed position to the open position. The electric circuit of the still camera 1 is disconnected from the power source when the slide cover 9 is slid from the open position to the closed position. An upper part, which serves as a finger support part 5a, of the vertically elongate boundary surface 5 of the body 2 is exposed as shown in Fig. 2 when the slide cover 9 is moved to the open position. The user's finger is put to the finger support part 5a when the user holds the still camera 1 for photographing.

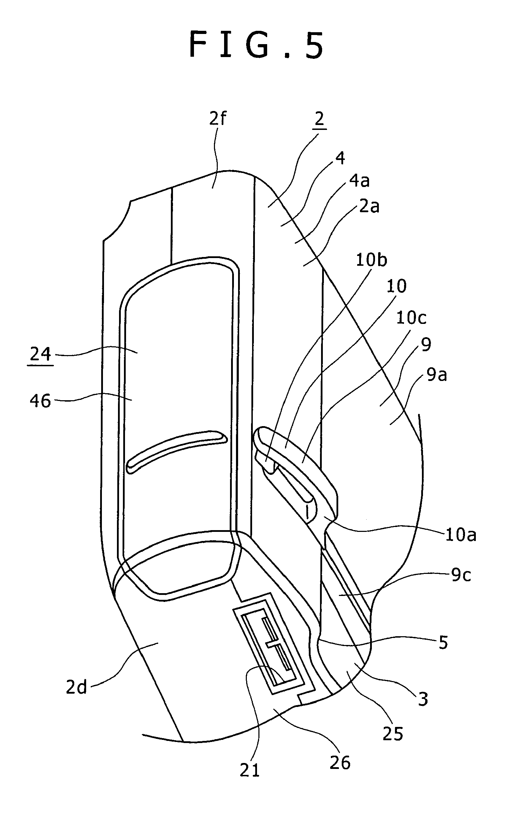

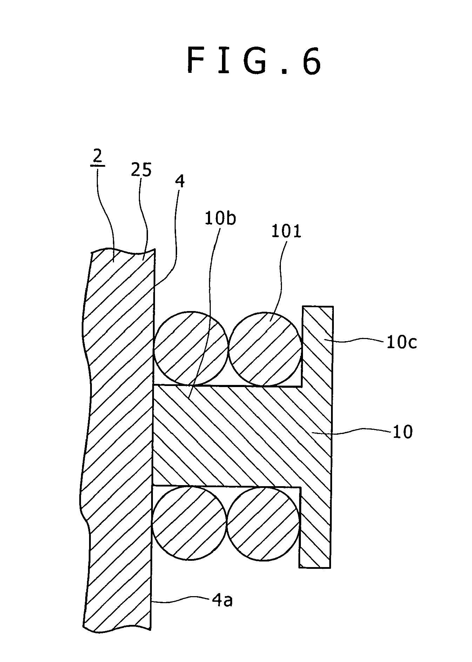

A strap lug 10 protrudes forward from a lower end part of the right end section 4. As shown in Fig. 5, the strap lug 5 has a protrusion 10a protruding forward from a left end part of the right end section 4, a strap peg 10b protruding forward from a right end part of the right end section 4, and a stopper 10c extending between the respective front ends of the protrusion 10a and the strap peg 10b. The protrusion 10a, the strap peg 1 0b and the stopper 10c are formed integrally. The stopper 10c over hangs the strap lug 1 0b entirely from the front side as shown in Fig. 6. One end part 101 of a strap 100 is wound round the strap peg 10b. Since the stopper 10c overhangs the strap peg 10b entirely, the end part 101 wound round the strap lug 10b is held behind the stopper 10c as shown in Fig. 6.

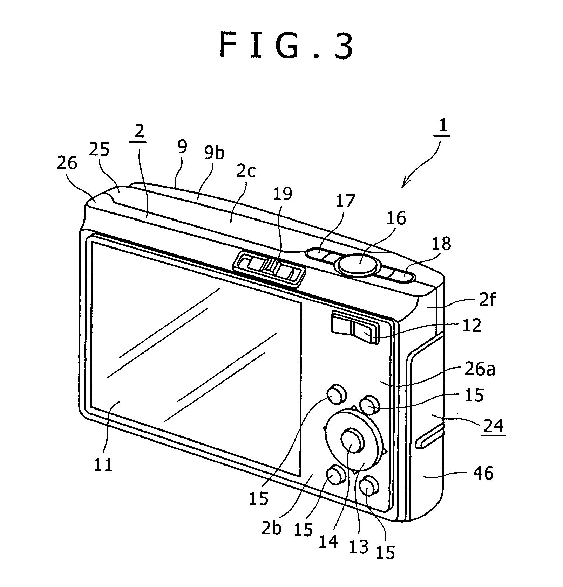

Referring to Fig. 3, a display panel 11, such as a liquid crystal display panel, is fitted in a left section of the rear wall 2b of the body 2. A zoom button 12 is disposed at a position near the upper end of a right section of the rear wall 2b. A first push button module 13 and a second push button module 14 are disposed at a position near the lower end of the right section of the rear wall 2b. Operating buttons 15 are arranged around the first push button module 13. A right part of the zoom button 12 is pressed for wide-angle photography, and a left part of the zoom button 12 is pressed for telephotography. The first push button module 13 has an annular shape. An upper part, a lower part, a right part and a left part of the first push button module 13 are pressed selectively to select a desired one of various modes including a flash photographing mode, a self-timer photographing mode, a photographed image display mode and a close-up photographing mode (macrophtographing mode). The second push button module 14 is fitted in the central opening of the first push button module 13. The second push button module 14 is pressed to execute a mode selected by pressing the first push button module 13. The push buttons 15 are operated to execute operations for displaying various menus, changing pictures displayed on the display panel 11, deleting photographed images and slide show.

A shutter button 16 is disposed at a part of the top wall 2c of the body 2 near the right end of the top wall 2c. The shutter button 16 is depressed for still photography and motion picture photography. On the top wall 2c of the body 2, a main switch button 17 is disposed on the left side of the shutter button 16 and a camera-shake prevention button 18 is disposed on the right side of the shutter button 16. When the main switch 17 is depressed repeatedly, the power source is alternately connected to and disconnected from the electric circuit of the still camera 1. When the camera-shake prevention button 18 is depressed, a camera-shake preventing function is actuated.

The power source is connected to the electric circuit when the slide cover 9 is slid from the closed position to the open position. The power source is disconnected from the electric circuit when the slide cover 9 is slid from the open position to the closed position.

A slide key 19 is disposed on a rear end part of the top wall 2c. The slide key 19 is a selector key for selecting a still picture photographing mode, a motion picture photographing mode or an image reproducing mode.

Referring to Fig. 4, a tripod connecting hole 20 and a connector 21 are arranged on the bottom wall 2d of the body 2. The tripod connecting hole 20 is used for connecting the still camera 1 to a tripod. The connector 21 is used for connecting the still camera 1 to an external device, such as a printer.

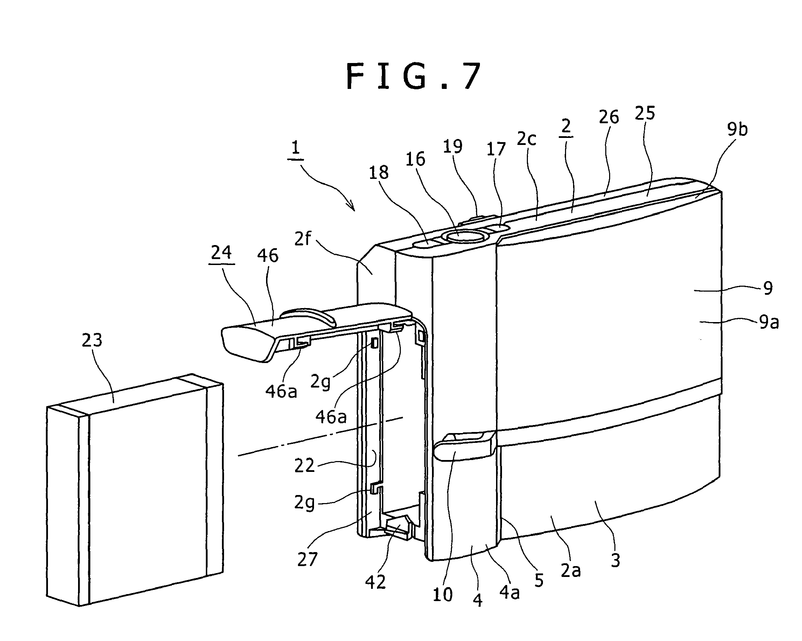

Referring to Fig. 7, the body 2 is provided with a cavity 22 opening in the right side wall 2f of the body 2. A rechargeable battery 23 is held in the cavity 22. The cavity 22 is covered with a swing lid 24.

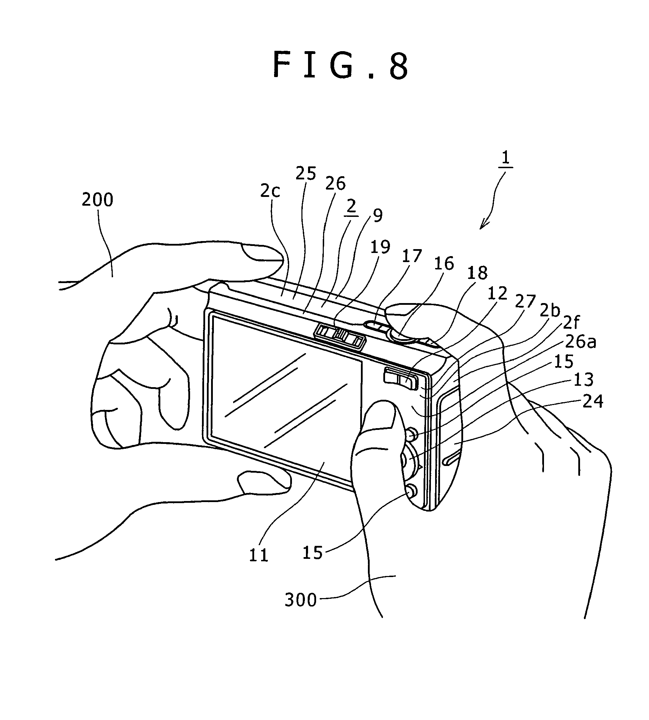

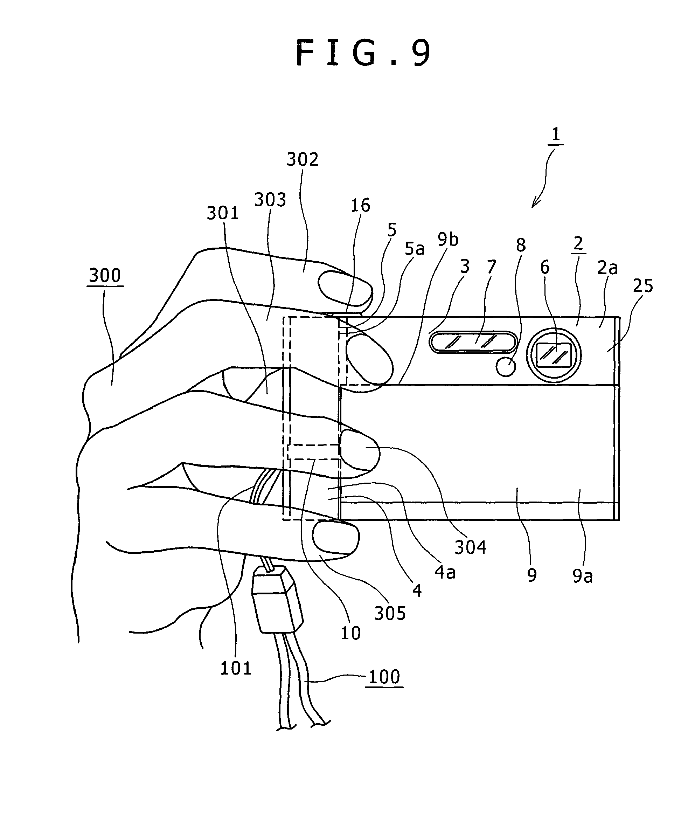

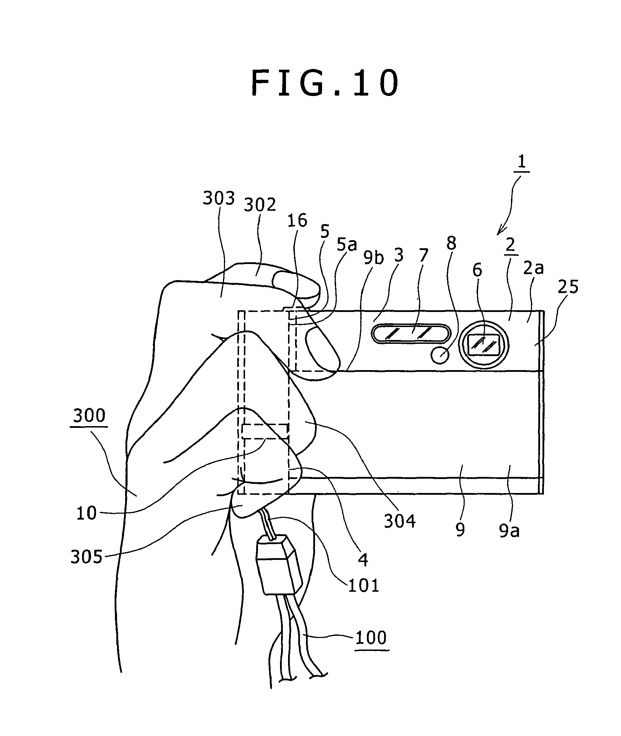

The user holds the still camera 1 in the left hand 200 and the right hand 300 for photographing as shown in Fig. 8. The still camera 1 can be held only in the right hand 300 for photographing as shown in Figs. 9 and 10. As shown in Fig. 9, A method of holding the still camera 1 with the slide cover 9 held at the open position only in the right hand 300 puts the thumb 301 to the rear wall 2b or the bottom wall 2d, puts the index finger 302 to the shutter button 16, places the middle finger 303 across the finger support part 5a and the upper end 9b of the slide cover 9, puts the third finger 304 on the strap lug 10, and puts the little finger 305 to the front wall 2a or the bottom wall 2d. As shown in Fig. 10, another method of holding the still camera 1 with the slide cover 9 held at the open position only in the right hand 300 puts the thumb 301 to the rear wall 2b or the bottom wall 2d, puts the index finger 302 to the shutter button 16, places the middle finger 303 across the finger support part 5a and the upper end 9b of the slide cover 9, bends the third finger 304, puts the bent third finger 304 on the strap lug 10, bends the little finger 305, and puts the bent little finger to the front wall 2a or the bottom wall 2d. Even if the strap 100 is attached to the strap lug 10, the end part of the 101 of the strap 100 will not interfere with the user's finger and the user can comfortably grip the still camera 1 because the end part 101 of the strap 100 is held behind the stopper 10c. Thus the strap lug 10 serves also as a finger rest.

The still camera 1 has the stepped or projecting finger support part 5a, the upper end 9b of the slide cover 9 and the strap lug 10. Therefore, the users fingers put to parts of the body 2 are prevented from slipping, the still camera 1 can be firmly held and the still camera 1 is handy.

In some cases, the middle finger 303 of the user holding the still camera 1 is placed across the front surface 4a of the right end section 4 of the body 2 and the front surface 9a of the slide cover 9. Since the front surface 4a of the right end section 4 and the front surface 9a of the slide cover 9 are gently curved continuous surfaces as mentioned above, the user can put the idle finger 303 across the front surface 4a of the right end section 4 of the body 2 and the front surface 9a of the slide cover 9 without feeling any wrong sensation.

Although the front surface 4a of the right end section 4 of the body 2 and the front surface 9a of the slide cover 9 are supposed to be gently curved continuous surfaces in the foregoing description, the front surface 4a of the right end section 4 of the body 2 and the front surface 9a of the slide cover 9 may be continuous flat surfaces. The user can put the idle finger 303 across the front surface 4a of the right end section 4 of the body 2 and the front surface 9a of the slide cover 9 without feeling any wrong sensation even if the front surface 4a of the right end section 4 of the body 2 and the front surface 9a of the slide cover 9 are continuous flat surfaces.

In the still camera 1, the display panel 11 is placed on the rear wall 2b of the body 2, and the shutter button 16 is placed on the top wall 2c. Therefore, an image displayed on the display panel 11 can be easily recognized and the finger can be easily put to the shutter button 16 when the still camera 1 is gripped by hands. Thus the visibility of the images on the display panel 1 l, and the operability and handiness of the still camera 1 are satisfactory.

The strap lug 10 that serves also as a finger rest when the still camera 1 is held for photographing is formed on the right end section 4 of the front wall 2a of the body 2. Therefore, the strap lug 10 does not move when the slide cover 9 is moved and hence the still camera 1 can be stably gripped.

Since the strap lug 10 serves also as a finger rest, the still camera 1 does not need any additional, special finger rest, which is effective in reducing the number of parts of the still camera 1 and in simplifying the construction of the still camera 1.

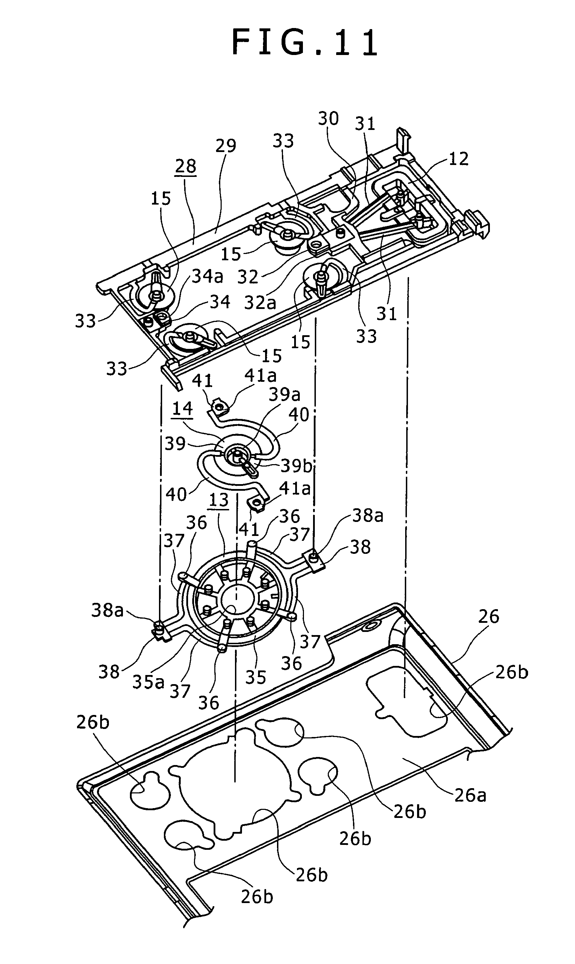

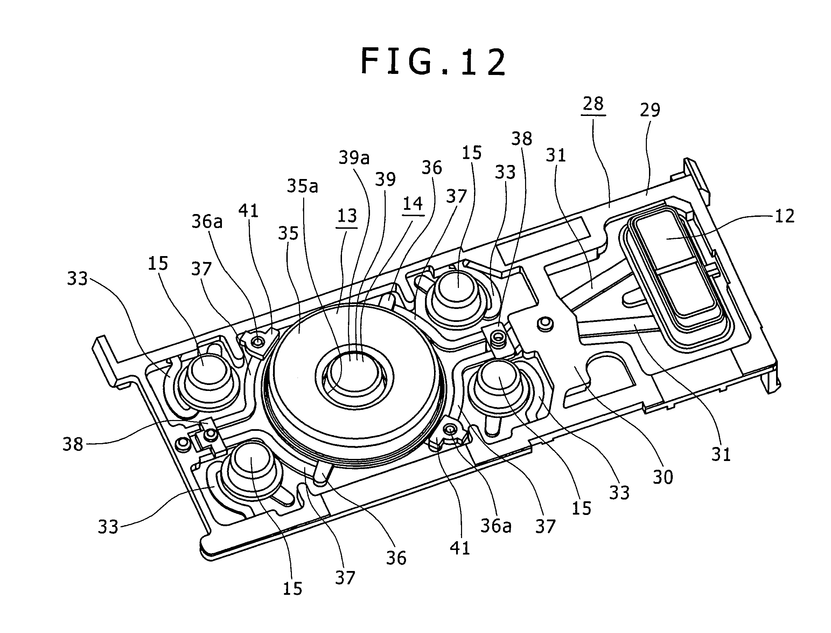

Referring to Fig. 3, the body 2 has a front panel 25, a rear panel 26 joined to the front panel 25, and a holding frame 27 interposed between the front panel 25 and the rear panel 26. As shown in Fig. 11, a right end section of the rear panel 26 serves as a button holding part 26a. The button holding part 26a is provided with openings 26b for receiving the buttons. A button unit 28 is attached to the front surface of the button holding part 26a with, for example, an adhesive. The button unit 28 has an elongate, rectangular frame 29, a connecting member 30 connecting right and left side members of the frame 29, elastic tongues 31 extending obliquely upward from a middle part of the connecting member 30, the zoom button 12 attached to the upper ends of the elastic tongues 31, an upper mounting lug 32 projecting downward from a middle part of the connecting member 30, elastic arms 33 projecting inward from predetermined parts of the frame 29, respectively, the buttons 15 attached to the free ends of the elastic arms 33, respectively, and a lower mounting lug 34 projecting upward from the lower end member of the frame 29. The button unit 28 including those members is made by molding a resin. The outside surface of the button unit 28 is finished by a plating process. The mounting lugs 32 and 34 are provided with holes 32a and 34a, respectively. A compound push button built by combining the first push button module 13 and the second push button module 14 is placed in an opening formed in the frame 29 as shown in Figs. 11 and 12.

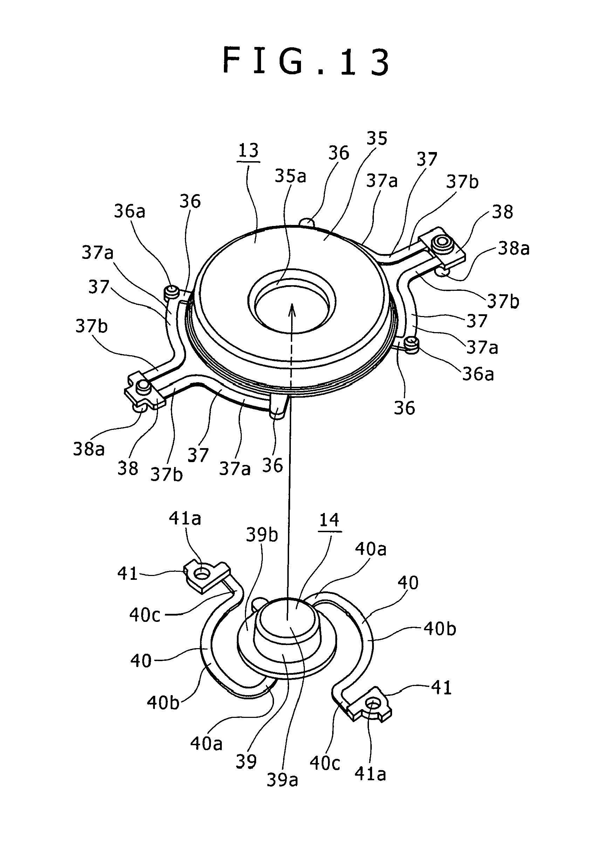

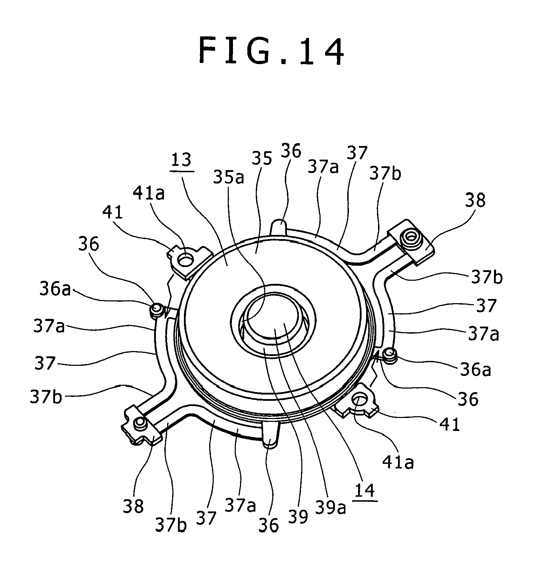

Referring to Figs. 13 and 14, the first push button module 13 has an annular operating button 35, four radial projections 36 arranged at equal angular intervals on and projecting from the circumference of the annular operating button 35, flexible parts 37 extending from the outer ends of the radial projections 36 substantially perpendicularly to the radial projections 36, respectively, and mounting parts 38 connected to the free ends of the flexible parts 37, respectively. The first push button module 13 having those members is formed by molding a resin. The outside surface of the first push button module 13 is finished by a plating process. The annular operating button 35 of the first push button module 13 is provided with a central opening 35a. The two diametrically opposite radial projections 36 are provided with backward projecting pins 36a, respectively. Each of the flexible members 37 has a circular part 37a extending along the circumference of the annular operating button 35, and a straight part 37b vertically extending from the free end of the circular part 37a. The straight parts 37b of the adjacent flexible parts 37 extend parallel to each other, and the free ends of the same straight parts 37b are connected to the mounting parts 38. The mounting parts 38 are provided with forward projecting pins 38a.

Referring to Fig. 13, the second push button module 14 has a central operating button 39, flexible legs 40 extending outward from the circumference of the central operating button 39, and connecting parts 41 connected to the free ends of the flexible legs 40. The second push button module 14 having those parts is formed by molding a resin. The outside surface of the second push button module 14 is finished by a plating process. The central operating button 39 formed in a substantially cylindrical shape has an operating part 39a, and a flange 39b connected to the inner end of the operating part 39a. The flexible legs 40 have diametrically opposite base parts 40a projecting radially outward from the flange 39b, substantially circular curved parts 40b extending from the free ends of the base parts 40a, respectively, along the circumference of the flange 39b, and end parts 40c extending from the curved parts 40b in opposite directions, respectively. The connecting parts 41 are provided with openings 41 a, respectively. The connecting parts 41 project in a circumferential direction from the end parts 40c, respectively.

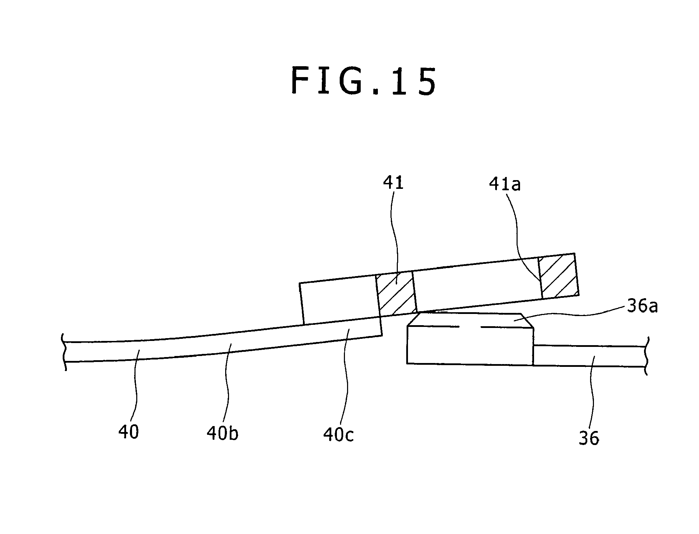

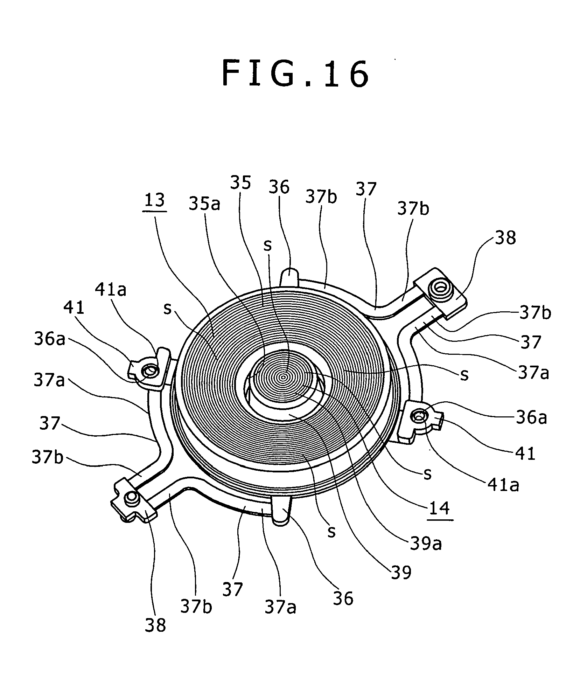

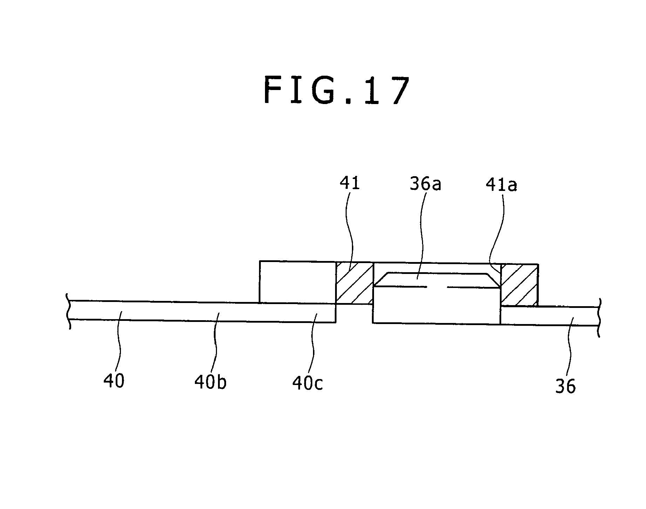

The first push button module 13 and the second push button module 14 are combined by a method which will be described below with reference to Figs. 13 to 17. First, the operating part 39a of the second push button module 14 is fitted in the central opening 35a of the annular operating button 35 of the first push button module 13. Then, the second push button module 14 is turned about the axis of the central operating button 39 to move the connecting parts 41 toward the pins 36a as shown in Fig. 14. The second push button module 14 is turned further, the flexible legs 40 are bent elastically forward, and the connecting parts 41 are brought into alignment with the pins 36a, respectively as shown in Fig. 15. Then, forces applied to the flexible legs 40 to bend the flexible legs 40 elastically are removed, and, consequently, the pins 36a are received in the openings 41a of the flexible legs 41, respectively. Thus the first push button module 13 and the second push button module 14 are combined completely as shown in Figs. 16 and 17. The pins 36a of the first push button module 13, and the openings 41a of the legs 41 of the second push button module 14 are first and second connecting parts, respectively.

In the compound push button thus built by combining the first push button module 13 and the second push button module 14, the connecting parts 41 of the second push button module 14 are pressed against the radial projections 36 of the first push button module 13 by the resilience of the flexible legs 40 of the second push button module 14 as shown in Fig. 17.

Referring to Fig. 12, after the first push button module 13 and the second push button module 14 have been combined, the pins 38a of the mounting parts 38 of the first push button module 13 are fitted in the holes 32a and 34a of the mounting lugs 32 and 34 of the button unit 28 from behind the mounting lugs 32 and 34, respectively. Thus the compound push button of the first push button module 13 and the second push button module 14 is attached to the button unit 28. After the compound push button of the first push button module 13 and the second push button module 14 has been thus attached to the button unit 28, the button unit 28 is attached to the front surface of the button holding part 26a with an adhesive or the like. After the button unit 28 has been thus fixed to the front surface of the button holding part 26a, the mounting parts of the first push button module 13 are held between the mounting lug 32 of the button unit 28 and the front surface of the button holding part 26a and between the mounting lug 34 of the button unit 28 and the front surface of the button holding part 26a, respectively, to hold the compound push button of the first push button module 13 and the second push button module 14 on the button holding part 26a. When the compound push button of the first push button module 13 and the second push button module 14 is thus held on the button holding part 26a, the zoom button 12, the annular operating button 35 of the first push button module 13, the central operating button 39 of the second push button module 14 and the operating buttons 15 are received in the openings 26b of the button holding part 26a, respectively, so as to protrude rearward from the button holding part 26a.

A wiring board provided with a switching circuit is disposed at a position in front of the button unit 28 in the body 2. The wiring board is provided with switches respectively corresponding to the zoom button 12, the first push button module, the second push button module 14 and the operating buttons 15.

When the zoom button 12 is pressed, the elastic tongues 31 of the button unit 28 are flexed elastically, the zoom switch is operated to actuate a zooming function. When the annular operating button 35 of the first push button 35 is pressed, the flexible parts 37 are elastically deformed and the switch corresponding to the pressed part of the annular operating button 35 is closed to actuate a desired function, such as a flash photographing function. When the central operating button 39 of the second push button module 14 is pressed, the flexible legs 40 are elastically deformed and the switch corresponding to the central operating button 39 is closed to actuate a predetermined function assigned to the central operating button 39. When each of the operating buttons 15 is pressed, a predetermined function, such as a menu displaying function, assigned to the operating button 15 is actuated.

In the still camera 1, the first push button module 13 and the second push button module 14 are combined by elastically warping the flexible legs 40 of the second push button module 14 in a direction in which the central operating button 39 of the second push button module 14 is fitted in the central opening 35a, and fitting the pins 36a of the radial projections 36 of the first push button module 13 in the openings 41a of the connecting parts 41 of the second push button module 14. Thus the first push button module 13 and the second push button module 14 do not need to be welded together, can be combined by simple combining work in a short time. When the first push button module 13 and the second push button module 14 are plated, the first push button module 13 and the second push button module 14 cannot be connected by welding because metal films coating the first push button module 13 and the second push button module 14 do not melt. The surfaces of the first push button module 13 and the second push button module 14 can be finished by a plating process when the first push button module 13 and the second push button module 14 are thus combined by fitting the pins 36a of the radial projections 36 of the first push button module 13 in the openings 41 a of the connecting parts 41 of the second push button module 14. When the first push button module 13 and the second push button module 14 are plated, fine, concentric, circular grooves s can be formed in the rear end surfaces of the annular operating button 35 of the first push button module 13 and the central operating button 39 of the second push button module 14 as shown in Fig. 16 by a spin patterning process to provide the same surfaces with a decorative appearance.

In the still camera 1, the pins 36a are first connecting parts, and the connecting parts 41 provided with the openings 41 a are second connecting parts, and the first push button module 13 and the second push button module 14 are combined by fitting the pins 36a in the openings 41a. Thus the first push button module 13 and the second push button module 14 can be easily combined.

The connecting parts 41 are pressed against the projections 36 of the first push button module 13 by the resilience of the flexible legs 40 of the second push button module 14 as shown in Fig. 17 when the first push button module 13 and the second push button module 14 are combined. Therefore, the first push button module 13 and the second push button module 14 do not shake and can be stably combined.

In the foregoing still camera 1, the first push button module 13 is provided with the pins 36a and the second push button module 14 is provided with the connecting parts 41 provided with the openings 41a. The openings may be formed in the first push button module 13 and the pins may be formed in the second push button module 14 to combine the first push button module 13 and the second push button module 14.

In the foregoing still camera 1, the pins and the connecting parts provided with the openings are used to combine the first push button module 13 and the second push button module 14. Projections may be formed in the first push button module 13 (the second push button module) and recesses may be formed in the second push button module 14 (the first push button module 13), and the first push button module 13 and the second push button module 14 may be combined by fitting the projections in the recesses, respectively. Hooks may be formed in the first push button module 13 and the second push button module 14, and the hooks may be engaged to combine the first push button module 13 and the second push button module 14.

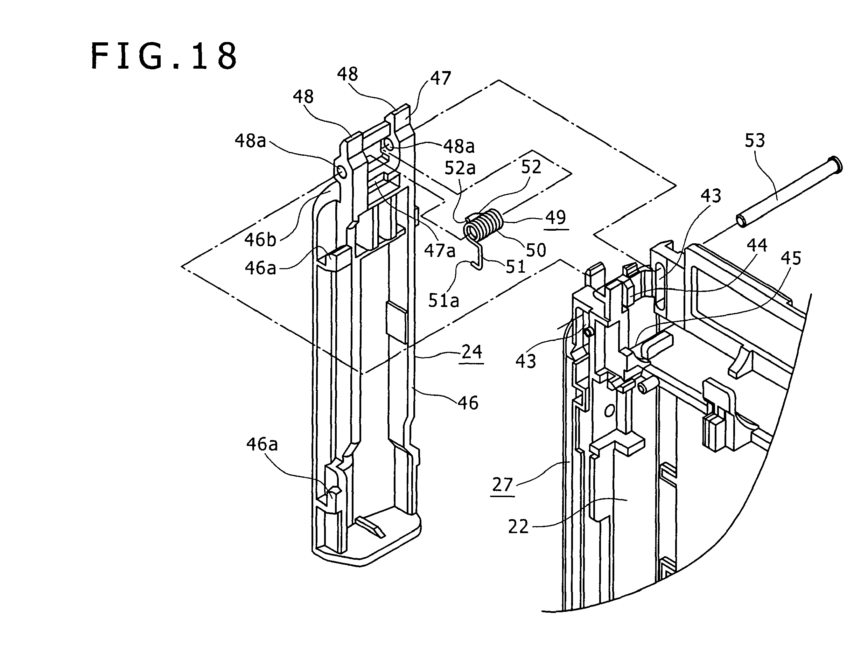

Referring to Figs. 7 and 18, the body 2 is provided with a cavity 22 opening in the right side wall 2f of the body 2. A battery locking member 42 is supported so as to be turnable on the lower edge of the holding frame 27 of the body 2 at the open end of the cavity 22 as shown in Fig. 7. Two locking projections 27a are formed at upper and lower positions, respectively, on each of a front side member and a rear side member of the holding frame 27 at the open end of the cavity 22. Only the locking projections 27a formed on the rear side member of the holding frame 27 are shown in Fig. 7. Vertically elongate slots 43 are formed in upper parts of the front and the rear side member of the holding frame 27, respectively, above the open end of the cavity 22 as shown in Fig. 18. The slots 43 penetrate the front and the rear side member in a direction parallel to the optical axis of the still camera 1.

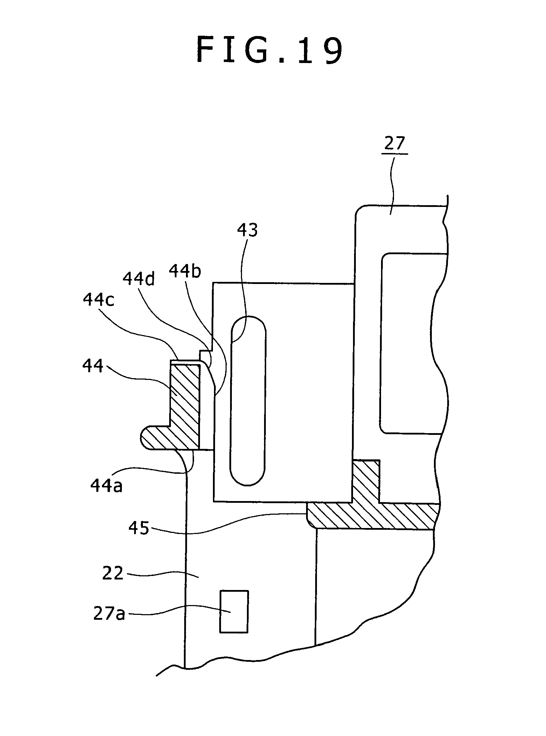

A vertically elongate stopping projection 44 is formed at an upper position of the right end part of the holding frame 27 as shown in Figs. 18 and 19. The stopping projection 44 has a lower end surface serving as a stopping surface 44a, a left side surface serving as a first retaining surface 44b, and an upper end surface serving as a second retaining surface 44c. An inclined surface 44d sloping obliquely upward so as to incline to the right extends between the first retaining surface 44b and the second retaining surface 44c of the stopping projection 44. A vertical through hole 45 is formed between the open end of the cavity 22 and the stopping projection 44 in the holding frame 27.

A swing lid 24 for covering the open end of the cavity 22 has an upper end part connected to the body 2 such that the swing lid 24 can turn on the body 2 as shown in Figs 3, 5 and 7. As shown in Fig. 18, the swing lid 24 has a lid body 46 and a projection 47, which are formed integrally in a unitary member. Two L-shaped catching parts 46a project forward or rearward from the front side surface of the lid body 46 and are vertically spaced apart. Two L-shaped catching parts 46a project forward or rearward from the rear side surface of the lid body 46 and are vertically spaced apart.

Suppose that the length of the swing lid 24 extends vertically as shown in Fig. 18. The projection 47 projects upward from a left half part of the upper end surface of the lid body 46. The upper end surface 46b of the lid body 46 is a stopping surface. The projection 47 has front and rear arms 48. The arms 48 are provided with through holes 48a, respectively. The through holes 48a extend in a direction parallel to the optical axis of the still camera 1. A surface of the projection 47 facing the right side wall 2f of the body 2 is provided with a spring retaining part 47a for retaining a coil spring 49. The coil spring 49 is disposed between the tongues 48. The coil spring 49 has a coil body 50, a first arm 51 extending from one of the opposite ends of the coil body 50, and a second arm 52 extending from the other end of the coil body 50. The respective end parts 51a and 52a of the arms 51 and 52 are bent substantially at right angles.

The swing lid 24 is supported for turning on the body 2 by a support shaft 53. As shown in Fig. 18, the support shaft 53 is passed forward through a slot 43 formed in a rear part of the holding frame 27, the through hole 48a formed in a rear part of the swing lid 24, the coil body 50 of the coil spring 49, the through hole 48a formed in a front part of the swing lid 24, and a slot 43 formed in a front part of the holding frame 27 in that order. The support shaft 53 can move vertically in the slots 43. The swing lid 24 can turn on the support shaft 53. When the support shaft 53 is moved vertically in the slots 43, the swing lid 24 moves vertically relative to the body 2 together with the support shaft 53. An upper limit position in a moving range of the swing lid 24 on the body 2 is an unturnable position where the swing lid 24 cannot turn, and a lower limit position in the moving range of the swing lid 24 on the body 2 is a turnable position where the swing lid 24 can turn.

In a state where the swing lid 24 is supported on the body 2, the first arm 51 of the coil spring 49 is elastically pressed against the spring retaining part 47a of the projection 46 from the left side, and the second arm 52 of the coil spring 49 is elastically pressed against the second retaining surface 44c, the inclined surface 44d or the first retaining surface 44b of the stopping projection 44 depending on the position of the swing lid 24 relative to the body 2.

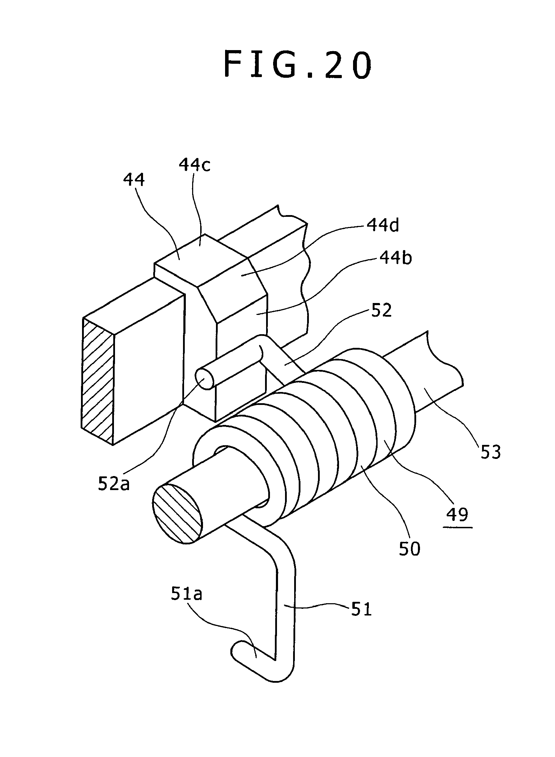

The second arm 52 slides on the stopping projection 44 between the second retaining surface 44c and the first retaining surface 44b as the position of the swing lid 24 relative to the body changes. A front part of the end part 52a of the second arm 52 bent at right angles projects forward from the stopping projection 44 as shown in Fig. 20. Therefore, the tip of the second arm 52 does not touch the stopping projection 44 when the second arm 52 slides on the stopping projection 44 between the second retaining surface 44c and the first retaining surface 44b and hence the stopping projection 44 will not be scratched by the stopping projection 44.

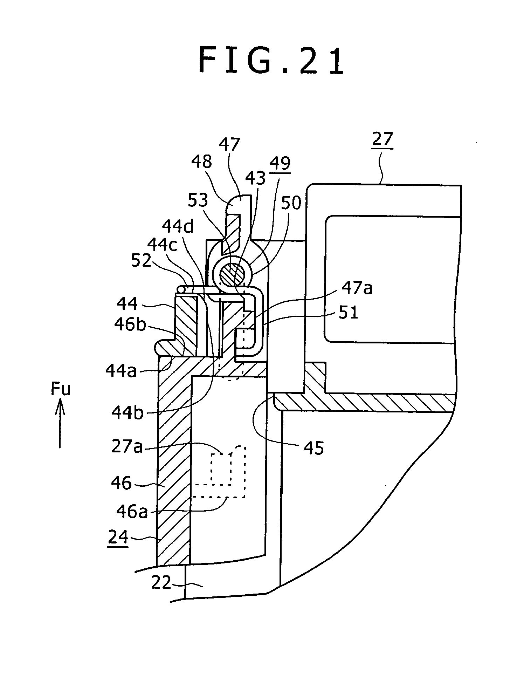

Motions of the swing lid 24 will be explained with reference to Figs. 21 to 27. In a state where the swing lid 24 is at the unturnable position, namely, the upper limit position in the moving range of the swing lid 24 as shown in Fig. 21, The projection 47 is extended upward into the through hole 45 of the holding frame 27, and the second arm 52 of the coil s-ring 49 is pressed against the second retaining surface 45c of the stopping projection 44. Consequently, the coil spring 49 exerts an upward force Fᵤ as indicated by the arrow in Fig. 21 on the swing lid 24 and the upper end surface 46b of the lid body 46 is pressed against the stopping surface 44a of the stopping projection 44 to restrain the swing lid 24 from turning relative to the body 2. In this state, the locking projections 27a formed at the open end of the cavity 22 are engaged with the catching parts 46a of the swing lid 24 to lock the swing lid 24 in place on the body 2.

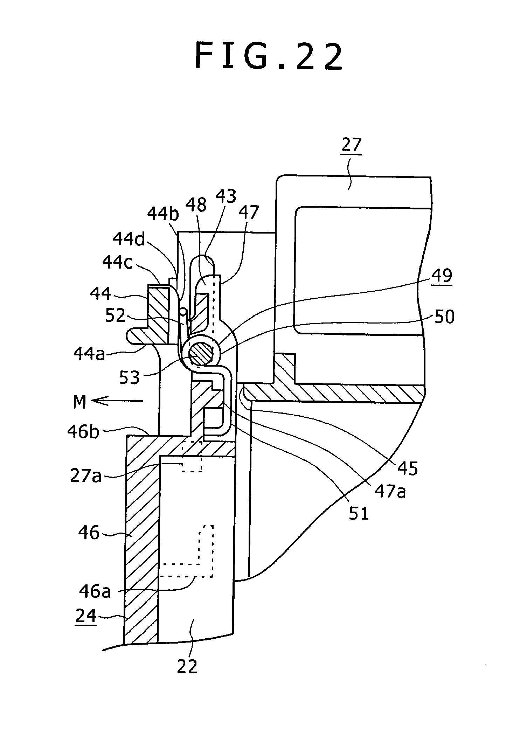

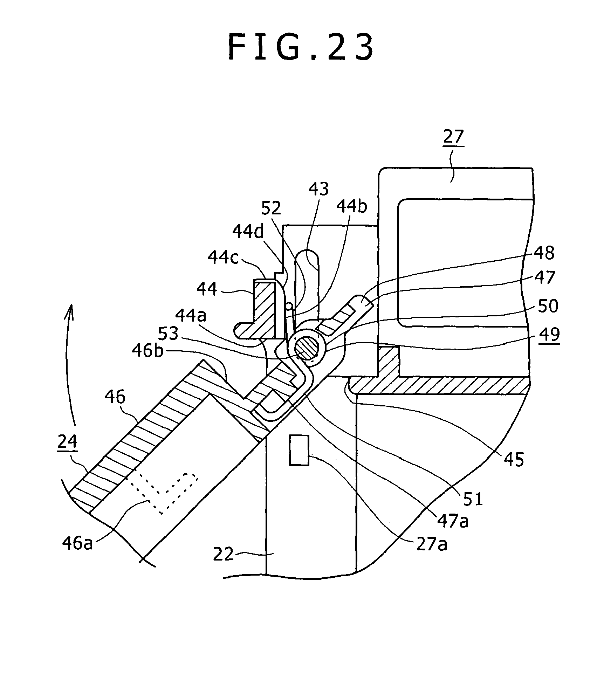

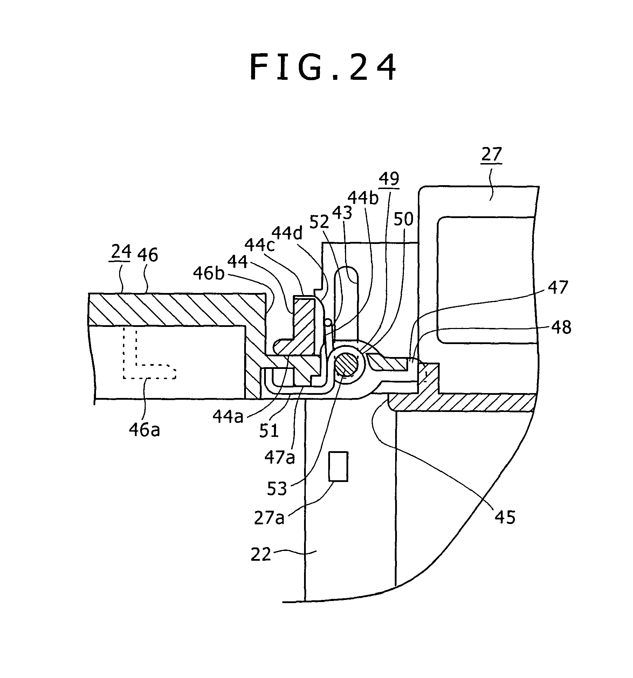

When the user slides the swing lid 24 down from the unturnable position by hand, the second arm 52 of the coil spring 49 slides from the second retaining surface 44c of the stopping projection 44 past the inclined surface 44d onto the first retaining surface 44b. During this movement of the first arm 52 of the coil spring 49, the support shaft 53 supporting the swing lid 24 slides down in the slots 43. Eventually, the swing lid 24 reaches the lower limit position, namely, the turnable position. When the swing lid 24 reaches the turnable position, the catching parts 46c of the swing lid 24 are disengaged from the locking projections 47a, and the first arm 51 of the coil spring 49 applies a rightward force as indicated by the arrow M in Fig. 22. Therefore, upon the separation of the user's finger from the swing lid 24, the swing lid 24 is turned relative to the body 2 on the support shaft 53 by the resilience of the coil spring 49 as shown in Fig. 23. The swing lid 24 is turned until the projection 47 comes into contact with the stopping surface 44a of the stopping projection 44 as shown in Fig. 24. Thus the cavity 22 is opened and the rechargeable battery 23 can be taken out from the cavity 22.

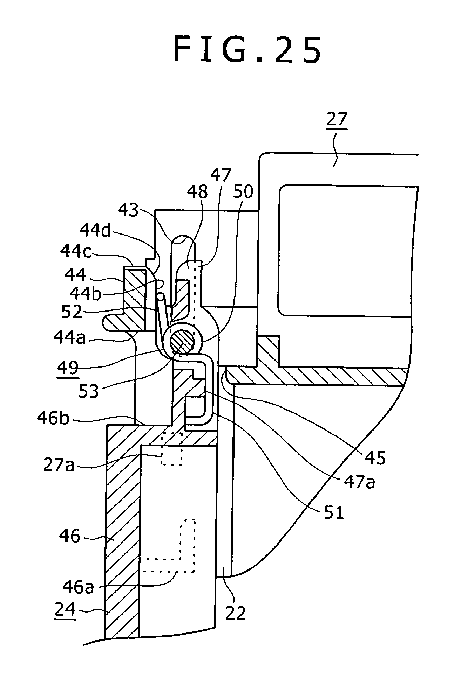

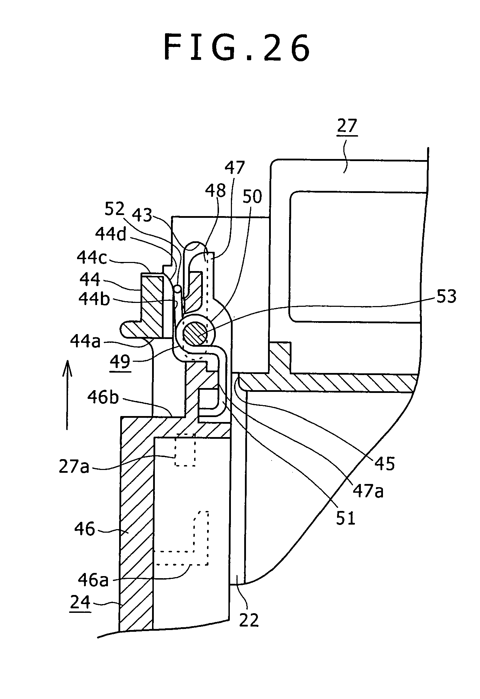

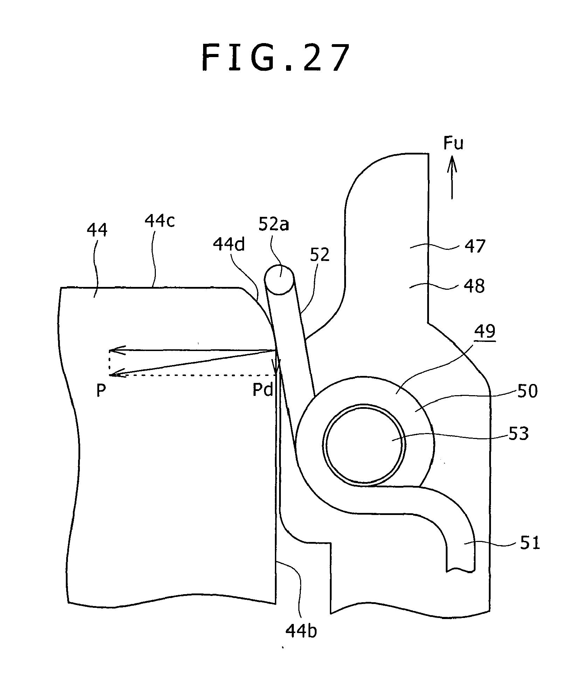

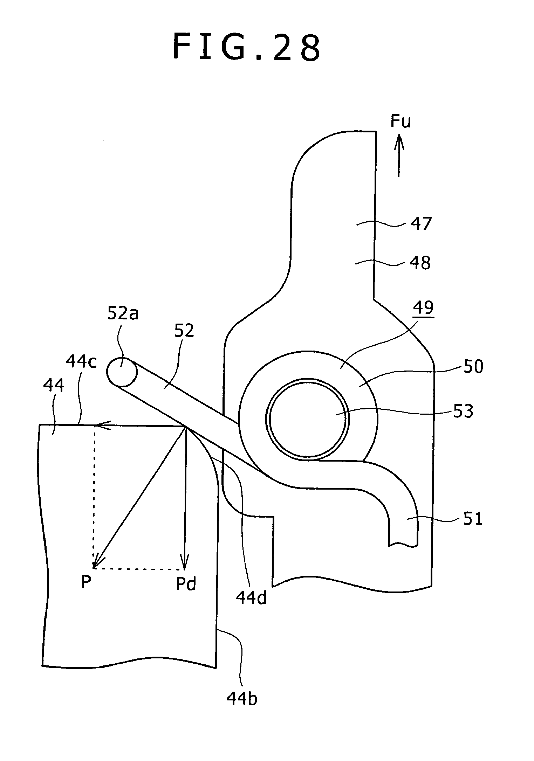

The rechargeable battery 23 held in the cavity 22 is locked in place by the battery locking member 42. The battery locking member 42 is turned to unlock the rechargeable battery 23, and then the rechargeable battery 23 can be taken out from the cavity 22. To put the rechargeable battery 23 into the cavity 22, the battery locking member 42 in a direction in which the same is turned to unlock the storage batter 23. The battery locking member 42 is turned in the reverse direction after the rechargeable battery 23 has been received in the cavity 22 to lock the rechargeable battery 23 in place in the cavity 22. The swing lid 24 is turned in the closing direction to the turnable position as shown in Fig. 25. Then, the swing lid 24 is pushed upward to slide the swing lid 24 upward on the body 2 to a position shown in Fig. 26. Consequently, the arm 52 moves from the first retaining surface 44b to the inclined surface 44d on the stopping projection 44 as shown in Fig. 27 and the second arm 52 is pressed against the inclined surface 44d by the resilience of the coil spring 49. Thus the second arm 52 applies a force P to the stopping projection 44. The force P acts obliquely downward as indicated by the arrow in Fig. 27. The force P can be decomposed into a horizontal component force and a vertical component force P_{d}. An upward force Fᵤ corresponding to a reaction force equal to the vertical component force P_{d} acts on the second arm 52. The second arm 52 is pushed upward by the upward force Fᵤ. Consequently, the swing lid 24 is moved upward automatically by the upward force Fᵤ after the user's finger has been removed from the swing lid 24. As the swing lid 24 is moved further upward by the upward force Fᵤ, the second arm 52 comes into contact with the boundary between the second retaining surface 44c and the inclined surface 44d as shown in Fig. 28. Then, the vertical component force P_{d} increases and hence the upward force Fᵤ increases. The increased upward force Fᵤ moves the swing lid 24 to the unturnable position shown in Fig. 21, the second arm 52 of the coil spring 49 is pressed against the second retaining surface 44d of the stopping projection 44, and the upper end surface 46b of the lid body 46 is brought into contact with the stopping surface 44a of the stopping projection 44. Thus the swing lid 24 is restrained from turning relative to the body 2. In a state where the swing lid 24 has been thus closed, the locking projections 27a of the holding frame 27 engage with the catching parts 46a of the swing lid 24 to hold the swing lid 24 at the unturnable position.

The swing lid structure of the still camera 1 is simple because the swing lid 24 is supported on the body 2 by the support shaft 53 so as to be slidable and turnable relative to the body 2. The coil spring 49 exerts the upward force Fᵤ on the swing lid 24 to slide the swing lid 24 from the turnable position to the unturnable position. The user does not need to move the swing lid 24 from the turnable position to the unturnable position entirely by a manual operation, which improves the handiness of the still camera 1.

Since the coil spring 49 exerts the upward force Fᵤ to move the swing lid 24 from the turnable position to the unturnable position, the swing lid structure is simple and the mechanism of the still camera 1 is simple, which reduces the manufacturing cost of the still camera 1.

In the still camera 1, the stopping projection 44 that restrains the swing lid 24 at the unturnable position from turning has the first retaining surface 44b and the second retaining surface 44c for retaining the first arm 52 of the coil spring 49. Therefore, the swing lid structure does not need to have two separate parts respectively for restraining the swing lid 24 at the unturnable position from turning and retaining the second arm 52 of the coil spring 49, which simplifies the swing lid structure.

Moreover, since the stopping projection 44 has the inclined surface 44d along which the second arm 52 of the coil spring 49 slides, the lid can be slid from the unturnable position to the turnable position by a small force and the upward force Fᵤ can be applied to the swing lid 24 at an early stage of sliding the swing lid 24 from the turnable position to the unturnable position.

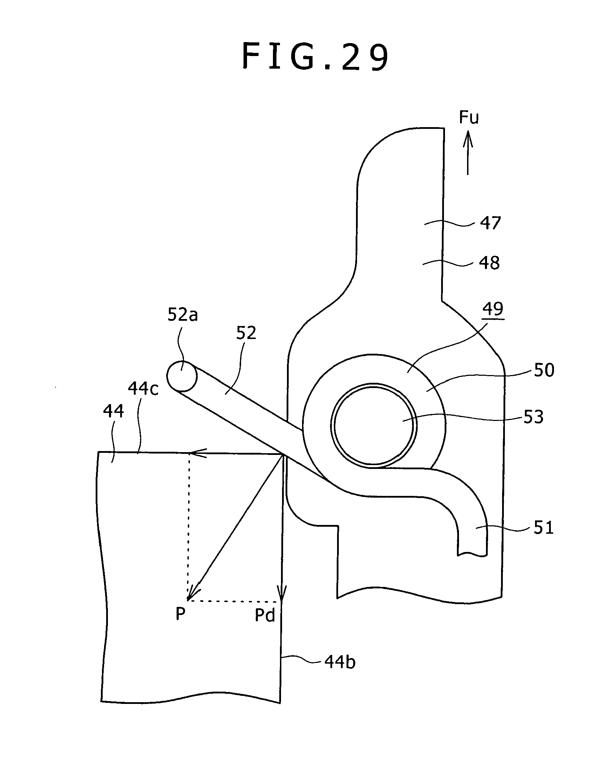

Although the inclined surface 44d is formed on the stopping projection 44 to apply the upward force Fᵤ top the swing lid 24 as mentioned above, the upward force Fᵤ can be applied to the swing lid 24 even if the stopping member 44 does not have the inclined surface 44d. For example, when the first retaining surface 44b and the second retaining surface 44c meet at an edge as shown in Fig. 29, an upward force Fᵤ corresponding to a downward component force P_{d} start acting on the swing lid 24 upon the rise of the end part 52a of the second arm 52 of the coil spring 49 past the edge where the first retaining surface 44b and the second retaining surface 44c meet.

Although the present invention has been described in its preferred embodiment with a certain degree of particularity, obviously many changes and variations are possible therein. It is therefore to be understood that the present invention may be practiced otherwise than as specifically described herein without departing from the scope thereof.

Whilst the embodiments described above each include explicitly recited combinations of features according to different aspects of the present invention, other embodiments are envisaged according to the general teaching of the invention, which include combinations of features as appropriate, other than those explicitly recited in the embodiments described above. Accordingly, it will be appreciated that different combinations of features of the appended independent and dependent claims form further aspects of the invention other than those, which are explicitly recited in the claims.

## Claims

1. A swing lid structure comprising:
a body having a cavity for holding a predetermined part therein and provided with slots extending in a predetermined direction;
a swing lid provided with through holes and capable of covering the cavity of the body; and
a support shaft passed through the through holes of the swing lid and slidably fitted in the slots of the body;
wherein the swing lid can slide on the body as the support shaft moves in the slots and can turn on the support shaft relative to the body.

2. The swing lid structure according to claim 1, further comprising a coil spring having a coil, a first arm extending from one of the opposite ends of the coil, and a second arm extending from the other end of the coil;
wherein the swing lid slide on the body between an unturnable position where the swing lid cannot turn relative to the body and a turnable position where the lid can turn relative to the body,
the swing lid is provided with a spring retaining part against which the first arm of the coil spring is pressed,
the body is provided with a stopping projection having a first retaining surface against which the second arm of the coil spring is pressed at least in a state where the swing lid is at the turnable position, and a second retaining surface against which the second arm of the coil spring is pressed in a direction from the unturnable position toward the turnable position when the swing lid is at the unturnable position.

3. The swing lid structure according to claim 2, wherein the stopping projection having the first and the second retaining surface has a stopping surface for restraining the swing lid at the unturnable position from turning relative to the body.

4. The swing lid structure according to claim 2, wherein the first and the second retaining surface extend perpendicularly to each other, and
the first and the second retaining surface are connected by an inclined surface inclined to the first and the second retaining surface such that the second arm of the coil spring slides along the inclined surface when the swing lid slides on the body.

5. An electronic apparatus comprising:
a body having a cavity for holding a predetermined part therein and provided with slots extending in a predetermined direction;
a swing lid provided with through holes and capable of covering the cavity of the body; and
a support shaft passed through the through holes of the swing lid and slidably fitted in the slots of the body;
wherein the swing lid can slide on the body as the support shaft moves in the slots and can turn on the support shaft relative to the body.
